# EUROPEAN PATENT APPLICATION

(11) **EP 4 712 704 A1**
(43) Date of publication of application: **18.03.2026**
(21) Application number: 24200917.3
(22) Date of filing: 17.09.2024
(51) Int. Cl.: H05K 1/02, G06N 10/40, H05K 1/14, H05K 1/18

(54) **SYSTEMS, COMPONENTS AND MECHANISMS TO SUPPORT ELECTRICAL SIGNAL TRANSMISSION IN LOW TEMPERATURE ENVIRONMENTS**

(71) Applicant: Microsoft Technology Licensing, LLC, Redmond, WA 98052-6399 (US)
(72) Inventor: PETERSSON, Karl David, Redmond, 98052-6399 (US); GRIGORYAN, Ruben, Redmond, 98052-6399 (US)
(74) Representative: Page White Farrer

(57) **Abstract**

Electrical communication between a sample (such as a quantum chip, semiconductor sample etc.) in a low temperature environment and an external device is effected via signal lines printed on rigid printed circuit board (PCB) located within a region of the low temperature environment (e.g., a non-uniform magnetic field region). One example application is performing a measurement of an electrical property of the sample at a low signal frequency with a short measurement integration time, although the subject matter is not limited in this respect. Another application is routing an electrical control signal to the sample.

## Description

### TECHNICAL FIELD

The present disclosure pertains to systems, components and mechanisms to support electrical signal transmission in low temperature environments.

### BACKGROUND

As emerging technologies such as quantum computing continue to progress at speed, there is an increasing need to support electrical communication in low temperature environments. For example, certain metals (such as aluminum) exhibit superconducting properties at very low temperatures. Superconductors have applications in certain solid state quantum chip architectures. For example, certain quantum processors use a superconductor-semiconductor nanoarchitecture. Semiconductor-based spin qubits systems also typically use very low temperature (<1K) operating temperatures.

A typical low-temperature setup includes a vacuum chamber coupled to a refrigeration mechanism to cool the interior of the vacuum chamber to very low temperatures. A sample holder holds a sample (such as a quantum chip) within the vacuum chamber. Signal lines located within the vacuum chamber connect the sample holder to an electrical interface at the edge of the vacuum chamber, bridging the interior and exterior, to provide electrical connectivity between the interior and the exterior. In some setups, a sample exchange mechanism is provided to enable a new sample to be loaded into the sample holder, whilst maintaining the low temperature of the interior.

Cryogen-free dilution refrigerators (also known as "dry cryostats") are popular, as no external supply of cryogenic liquids is needed, and their operation can be readily automated. Dilution refrigerators have been used in research applications, for example to cool down semiconductor samples; to study novel superconductors when combined with superconducting magnets; or in quantum computing research. As such technologies move from research to commercialization, issues of scalability need to be addressed.

### SUMMARY

This summary is provided to introduce a selection of concepts in a simplified form that are further described below in the Detailed Description. This Summary is not intended to identify key features or essential features of the claimed subject matter, nor is it intended to be used to limit the scope of the claimed subject matter. Nor is the claimed subject matter limited to implementations that solve any or all of the disadvantages noted herein.

In example aspects disclosed herein, electrical connection between a sample (such as a quantum chip, semiconductor sample etc.) in a low temperature environment and an external device is effected via signal lines printed on rigid printed circuit board located within a region of the low temperature environment (for example, a non-uniform magnetic field region). One example application is performing a measurement of an electrical property of the sample at a low signal frequency with a short measurement integration time, although the subject matter is not limited in this respect. Another application is routing an electrical control signal to the sample.

### BRIEF DESCRIPTION OF FIGURES

Particular embodiments will now be described, by way of example only, with reference to the following schematic figures, in which:
FIG. 1 shows a schematic diagram of an example dilution refrigerator;
FIG. 2 shows a schematic diagram of a pulse tube refrigerator;
FIG. 3 schematically illustrates a first example motherboard design;
FIG. 4 schematically illustrates a second example motherboard design;
FIG. 5 shows a schematic block diagram of an example system;
FIG. 6 shows results of experiments to measure vibration-induced electrical noise with different motherboard designs; and
FIG.7 shows a schematic block diagram of an example implementation.

### DETAILED DESCRIPTION

Example embodiments address specific challenges which the inventors have identified in modern dry cryostats. Such systems are known to suffer from issues of mechanical vibrations. For example, a pulse tube refrigerator (PTR) uses a mechanism to create pressure changes, such as a moving piston or a rotary valve to alternately connect between high and low pressure sides. A significant level of mechanical vibration is inherent to this process.

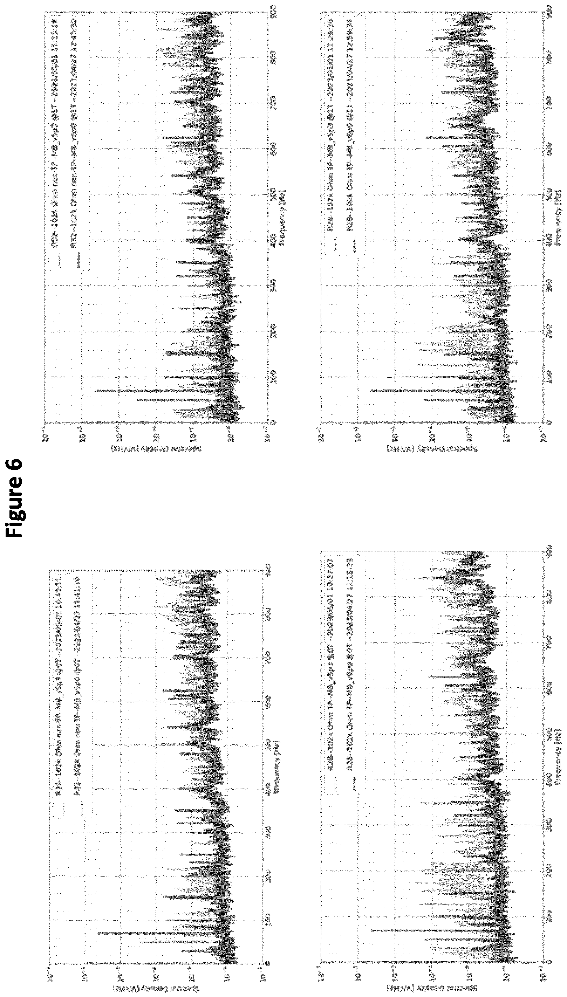

However, whilst the issue of mechanical vibrations is known, the full implications have not been appreciated. Particular issues have been identified when measurements and/or control operations need to be performed on a quantum chip (e.g. quantum processor, quantum sensor etc.) or other sample (e.g., semiconductor sample) in a very low temperature environment, via electrical signals carried by signal lines located within the cryostat. Surprisingly, it has been observed (see Figure 6) that, in such contexts, mechanical vibration of the signal lines is a significant source of electrical noise on the signal lines at lower frequencies. Particular issues arise with a sample in a magnetic field. In some setups, a dominant source of vibration-induced noise is indictive noise caused by paired signal lines vibrating in a non-uniform magnetic field region. A secondary source of noise is triboelectric noise.

One way to circumvent the problem of low-frequency vibration-induced electrical noise on the signal lines would be to use higher-frequency signals, to avoid material overlap between the signal spectrum and the noise spectrum (mechanical vibrations are usually negligible above 100kHz or so). However, this is not always feasible in practice. When performing measurements (such measuring a resistance or impedance of a low-temperature sample), another way to circumvent the problem would be to use an increased measurement integration time. However, this imposes a limit on the speed at which measurements can be performed.

Vibration-induced electrical noise is a particular issue when performing measurements on a sample at low signal frequencies and with short integration times. The need to reduce integration times arises, for example, in quantum computing, quantum sensing etc., as the ability to perform measurements quickly is important to achieve scalability of quantum devices and the like. The issue of vibration-induced electrical noise in the signal lines would not have been evident from earlier experiments with longer measurement integration times.

Moreover, depending on the physics of the sample, noise and heat induced by mechanical vibrations could affect performance of a sample at any signal frequency.

In the described embodiments, the issue of vibration-induced electrical noise is addressed by routing low frequency signal lines in a dilution refrigerator at least partly in rigid printed circuit board (PCB). In one example setup, the sample carrier is enclosed in a fast sample exchange system, with the low-frequency lines routed in rigid PCB inside a fast sample exchange puck. A fast sample exchange system is an addition to a standard dilution fridge that allows a sample in a vacuum chamber to be exchanged with another sample at increased speed (e.g., a couple of days compared with a week for a fridge without such a system). As noted, with a sample placed in a magnetic field, it has been observed that the signal lines can act as magnetic pick-up loops, thus creating electrical noise on the signal lines through electromagnetic induction in any region(s) of non-uniform magnetic field in which paired signal lines are vibrating. This issue is addressed by tightly spacing the signal lines on the printed PCB (e.g., with a spacing of approximately 150 micrometers or less) within a non-uniform magnetic field region. The combination of rigid PCB and tight line spacing in the non-uniform magnetic field region is highly effective in reducing inductive pickup noise because the rigidity of the PCB reduces relative vibrational movement between the signal lines and the tight spacing reduces the area of the pickup loop within the non-uniform magnetic field region. This tight spacing is more achievable because the signal lines are printed on rigid PCB, which is a secondary benefit to the use of rigid PCB to define and route the signal lines. The spacing between lines depends, in part, on PCB manufacturing capabilities. Reducing the spacing significantly below 150 micrometers is possible, but could have the effect of increasing capacitance between the measurement lines. Spacing of around 150 micrometers has been found to achieve good performance in practice. However, the optimal spacing will be context dependent. Finding a spacing in a given context that, on the one hand, reduces the size of the pickup loops sufficiently and, on the other hand, maintains a reasonably low capacitance between measurement lines will be a matter of routine experimentation. Elsewhere in the cryostat, tiny flexible copper or bronze wires are used in one embodiment. Although flexible, these wires do not pick up magnetic noise because they are located away from the non-uniform magnetic field region.

Moreover, the use of rigid PCB also reduces other forms of vibration-induced noise, such as triboelectric noise.

Sample carriers (also known as sample holders) that can support samples in low-temperature environments are commercially available. In alternative embodiments, a sample is directly attached to the rigid PCB.

In some embodiments, the signal lines are routed in multi-layer rigid PCB to further reduce the area of the magnetic pick-up loops, as it enables the signal lines to be stacked.

Example embodiments are described in further detail below. First, additional relevant context to the described embodiments is provided.

A dilution refrigerator is a cryogenic device that provides continuous cooling, reaching temperatures as low as 2mK. Certain embodiments operate at slightly higher temperatures, such as around 10mK.

The cooling power of a dilution refrigerator is provided by the heat of mixing of two isotopes of helium, ³He and ⁴He. At low temperatures, below around 0.87 K, a mixture of³He and ⁴He will separate into two phases: a concentrated, ³He-rich phase and a dilute, ³He-poor phase. Since the enthalpy of ³He is larger in the dilute phase than in the concentrated phase, energy is required to move ³He atoms across the phase boundary from the concentrated phase to the dilute phase. In a dilution refrigerator, this energy is taken from a well-isolated environment, causing cooling.

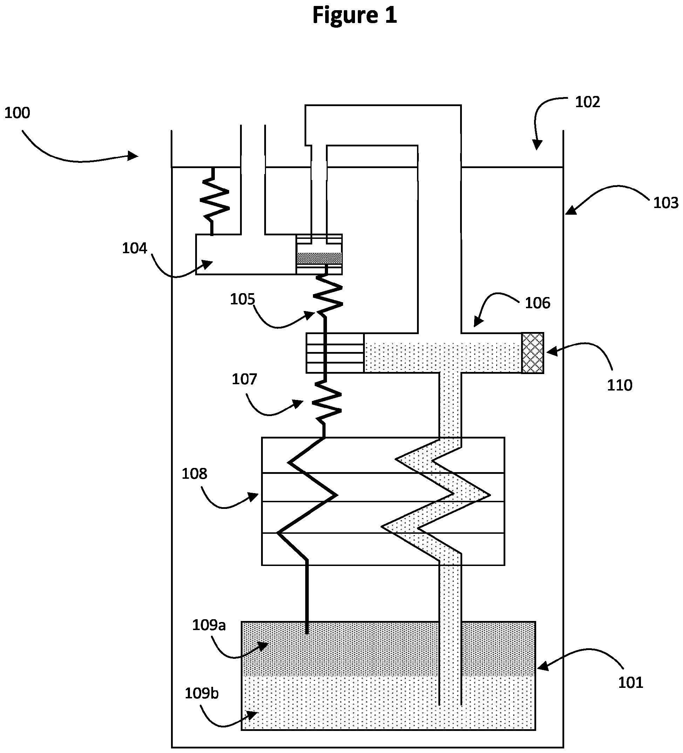

FIG. 1 shows a schematic diagram of an example dilution refrigerator 100, where the isolated environment is provided in the form of a mixing chamber 101. This is where the isotopes are mixed and where the ³He is pumped through the phase boundary to provide the cooling power.

Before reaching the mixing chamber 101, the ³He is precooled. In a classical, or "wet" dilution refrigerator, this is achieved using liquid nitrogen at 77 K and a ⁴He bath 102 at 4.2 K. Examples of dry refrigeration mechanisms are considered below. The ³He then enters a vacuum chamber 103, where it is further cooled by a vacuum-pumped ⁴He bath 104 at 1K. The 1 K bath 104 liquefies the ³He and removes the heat of condensation.

The precooled ³He then enters a main impedance 105, which is a capillary with a large flow resistance. It is then further cooled to around 500-700 mK by a distiller, or "still" 106. The ³He then flows through a secondary impedance 107 and one side of a set of counterflow heat exchangers 108, where it is cooled even further by a cold flow of³He flowing in the opposite direction through the other side of the set of heat exchangers 108. The pure ³He then finally enters the mixing chamber 101, which is the coldest part of the dilution refrigerator 100.

Inside the mixing chamber 101, the two phases, concentrated and dilute (109a and 109b respectively), are in equilibrium and separated by a phase boundary. As the ³He flows across the phase boundary, from the concentrated phase 109a to the dilute phase 109b, it is diluted. The process of moving the ³He across the phase boundary to dilute the ³He is endothermic, and so removes heat from the mixing chamber 101.

The cold dilute ³He is driven back up and out of the mixing chamber 101 by a pressure gradient. The cold ³He flows through the heat exchangers 108, cooling the downward flowing concentrated ³He, and then enters a still 106, which distills the ³He from the ⁴He. Heat is applied to the still 106 by a heater 110; this maintains the still at a temperature at which ³He has a higher partial pressure than ⁴He. Vacuum pumps compress the ³He and feed it back into the cryostat, completing the cycle.

In cryogen-free, or "dry" dilution refrigerators, the precooling stage is achieved without the use of cryogenic liquid baths. For example, modern dry dilution refrigerators commonly use PTRs as precoolers, which are low-cost and simple to operate.

PTRs achieve cooling through a process of cyclic compression and expansion of a working fluid.

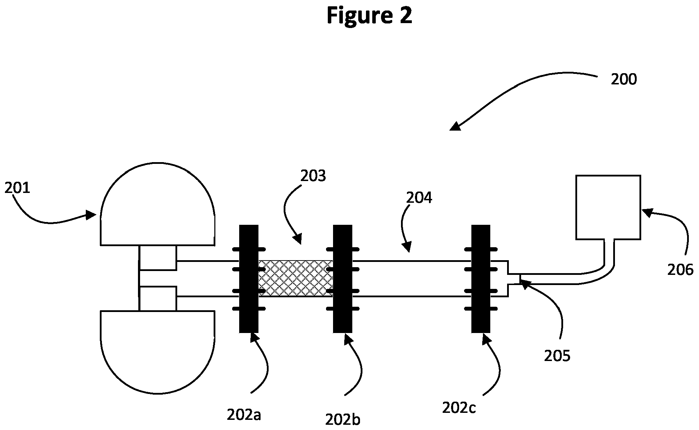

FIG. 2 shows a schematic diagram of a Stirling-type single-orifice PTR 200, in which a tube is filled with a gas, such as helium, at ambient temperature. A compressor 201 compresses the gas in a compression chamber, increasing the temperature and pressure of the gas. The high-pressure gas then flows through a heat exchanger 202a, and then through a regenerator 203. The regenerator 203 is formed of a porous medium with a large specific heat, such as copper wire mesh. As the high-pressure gas moves through the regenerator 203, heat is transferred from the gas to the regenerator 203, reducing the temperature of the gas to ambient temperature.

Next, the gas flows through a second heat exchanger 202b into a "cold" side of a pulse tube 204. As the high-pressure gas travels across the pulse tube 204, from the cold side to a "hot" side, it compresses the gas in the tube, causing it to heat up. A third heat exchanger 202c then removes heat from the gas at the hot side of the tube. The gas is forced through an orifice 205 into a buffer tank 206.

When the compressor 201 is reversed, the gas inside the pulse tube 204 expands, causing the temperature of the gas to drop below ambient temperature. This causes a cooling effect on the cold side of the pulse tube 204. The second heat exchanger 202b, at the cold side of the pulse tube 204, will then absorb heat; this system may thus be used to precool the ³He in the dilution refrigerator.

In use, a sample (not depicted) is located at or in proximity to the cold end, e.g. thermally coupled to the coldest part of the dilution refrigerator.

Dilution refrigerators are often used to cool down a sample (for example, a quantum device, such as a solid-state quantum chip) to perform electrical measurements (for example, quantum transport measurements) designed to characterize the sample in a low-temperature regime.

In such measurements, low-frequency (a few - 10s or 100s of Hz) interference is often observed. If the signal-to-noise ratio is low, it can be difficult to extract useful data from measurements. One way to minimize the impact of noise is to integrate over the signal for longer. While this may be acceptable for smaller-scale measurements, long integration times are far from ideal for large-scale characterization experiments or scalable commercial implementations, since this can lead to dramatic, and often impractical, increases in the time required to complete the measurements.

There is therefore a requirement for alternative methods of minimizing the noise in electrical measurements performed on materials cooled by dilution refrigerators. This is especially important for low-frequency measurements (e.g., of the order of 1 kHz or less). In one embodiment, a low-frequency probing signal(s) is used to perform lock-in measurements on a sample.

The precoolers used in dry dilution refrigerators (such as pulse tube coolers) cause mechanical vibrations. As noted, the inventors have developed insights into the contribution of such vibrations to noise observed in electrical measurements on signal lines: the mechanical vibrations couple to wires within the signal lines, causing the wires to vibrate. One issue is that, in certain setups, the mechanical vibrations cause a change in the magnetic flux through the loop (formed by the wires), either through displacement of the loop in a non-uniform magnetic field, or through a change in the area of the pick-up loop. The change in magnetic flux, in turn, generates an electromotive force at the vibrations frequencies. If vibration spectrum is broad, a broad spectrum of electrical interferences appears in the measurements. The vibrations themselves can also be problematic: although this problem can be mitigated to a certain extent by using copper braids to decouple the pulse tubes from the experimental plates, at the extremes of vibration sensitive applications, for example in scanning probe measurements, the remaining vibrations can still interfere with measurements. This problem will also scale with the cooling power required, since greater cooling power will require more pulse tube coolers, and thus the system will experience greater vibrations.

For some characterization methods, it is necessary to place the material in a magnetic field. Setups therefore often comprise dilution refrigeration systems which incorporate large solenoid magnets. This introduces an additional source of noise. At the edges, the field from the magnet is non-uniform. The mechanical vibrations of the pulse tube coolers cause loose wires to vibrate; the vibration of the wires in the non-uniform magnetic field induces an electromotive force, causing interference in the electrical measurements. The sample is held in a uniform magnetic field region, whose size is limited in practice (e.g. when a fast sample exchange system is used, the size may depend on the physical properties of a sample exchange system). Therefore, a non-uniform magnetic field region within the cryostat, through which the signal line(s) pass, may be unavoidable.

There is therefore a need to minimize the effect of mechanical vibrations caused by pulse tube coolers in dry dilution refrigerators on electrical measurements.

The mechanical vibrations caused by the pulse tube coolers are a feature of the setup and cannot be eliminated. Instead, example embodiments minimize the coupling of the mechanical vibrations to the electrical measurements performed on a sample in the dilution refrigerator by improving the design of the motherboard used to facilitate the measurements.

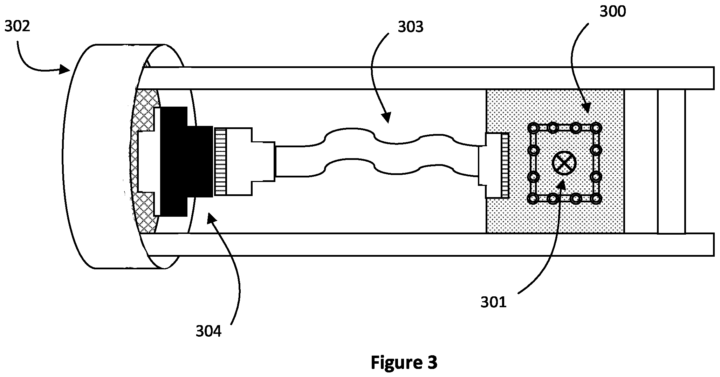

FIG. 3 schematically illustrates a conventional motherboard design. A motherboard 300 is fixed inside a metal casing 302, which is typically mounted in a vacuum chamber. A sample 301 (such as a quantum chip to be operated) is coupled to the motherboard 300. To connect the sample 301 to an interface 304 with the external system, current is routed through signal lines in the form of relatively long, flexible cables 303. In Figure 3 only one flexible cable 303 is shown, but there may be multiple flexible cables in other setups. The flexible cables 303 are free to move and bend, which leads to two problems. Firstly, the mechanical vibrations from the pulse tube coolers can couple to the wires within the cables, causing them to vibrate. Secondly, if a magnetic field is present, these cables can form large pick-up loops and are therefore susceptible to magnetic interference. These effects result in noise in electrical measurements. In some implementations, a loop is formed from an ambient temperature exterior, to a cryogenic wire, to a sample-cryogenic wire, finally returning to the ambient temperature exterior.

In the described embodiments, an improved motherboard design is provided, in which no flexible cables are used within regions of high magnetic field gradient inside a refrigerated vacuum chamber. Instead, the routing is printed into the motherboard. In some implementations, flexible lines are used through most of the cryostat. However close to the magnet field centre where a strong magnetic field gradient is exhibited, rigid PCB lines are used. In other implementations, suitable rigid PCBs is used throughout the entire cryostat.

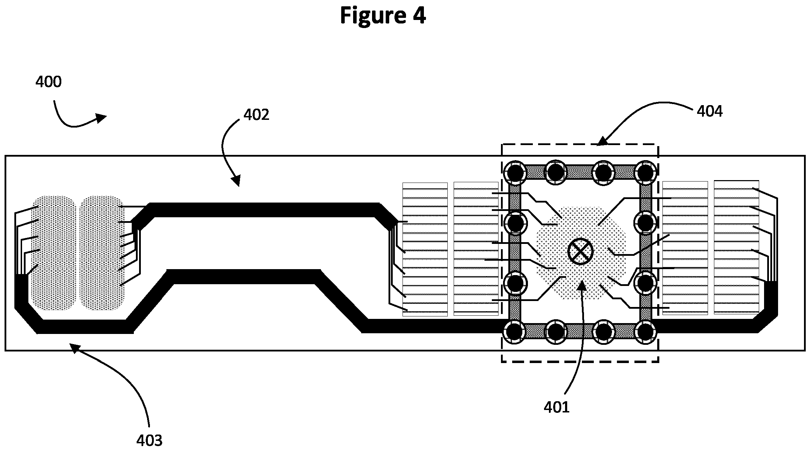

FIG. 4 shows an improved motherboard design. A motherboard 400 is made of rigid PCB that is sufficiently rigid to reduce the electrical noise caused by mechanical vibrations to manageable levels. In general, commercially available rigid PCB should be more than sufficient to meet these requirements. In use, a sample is rigidly and electrically coupled to a sample region 404 of the motherboard 400. For example, the sample may be contained in a sample holder that is attached to (e.g., screwed in) to the sample region 404 of the motherboard, providing a rigid mechanical coupling and also an electrical coupling to the motherboard 400. Note, the term sample holder has several meanings in the field, sometimes referring to a daughterboard, sometimes a motherboard and sometimes an entire quick sample exchange puck. Herein, unless otherwise indicated, the term sample holder is used to mean a daughterboard attachable to a motherboard and configured to hold a sample. One or more low-frequency (e.g. DC) signal lines 402 are printed into the rigid PCB motherboard 400. The low-frequency signal line(s) 402 connects the sample to an interface region 403 to which an external electrical interface (not shown) can be connected. The sample holder 404 includes a light-tight copper shielding that shields the sample. In an alternative embodiment, a sample is directly attached (e.g., glued) to the sample region 404 of the motherboard, without a sample holder.

The rigid PCB prevents PCB-relative movement of the signal line(s) 402, which has several benefits. One benefit is a reduction of inductive pickup in a nonuniform magnetic field region due to due to reduced mechanical vibrations. In one implementation, the reduction in inductive pickup noise is achieved through a combination of reduced mechanical movement in the non-uniform magnetic field region and a reduction in the area of pickup loops formed by the signal line(s) 402 within the non-uniform magnetic field region (achieved by reducing their relative spacing). Another benefit is a reduction in triboelectric noise.

The improved motherboard design minimizes the effects of the mechanical vibrations caused by the pulse tube coolers on the measurements. Because the signal line(s) 402 is printed into the rigid PCB motherboard 400, there are no loose wires; the inductive pickup noise and triboelectric noise caused by the mechanical vibrations from the pulse tube coolers is therefore minimized. Furthermore, printing the wires into the motherboard 400 enables the low-frequency routing to be very tightly packed (for example, 48 DC lines may be printed with a total width of only 5mm). The spatial variation of the non-uniform magnetic field is smaller over shorter length scales. Tight packing of the low-frequency signal lines minimizes the area of the pick-up loops and thus reduces the susceptibility to magnetic interference.

Some types of wiring are more susceptible to triboelectricity than others. For example, cryogenic wires made of enamel plated Cu, constantan or bronze are less susceptible to triboelectricity than conventional Cu wires with PU or Teflon isolation. Thus, in practice, inductive pickup noise may be a more significant issue in practical cryogen setups.

The total area of a loop formed by wiring is large if the full length of the wiring is considered (e.g., several meters in some setups). However, the gradient of the magnetic field is largest near the sample. It is more important to minimize loop pick-up area in region(s) where the magnetic field gradient is highest. In the rigid PCB design described herein, this area essentially coincides with the length of a signal line printed on the motherboard (e.g., around 200mm). With 200mm lines and the spacing between two lines of 0. 15mm, a loop has an area of 30mm² in this area of high magnetic field gradient (a reduction by a factor of ten or so compared with a more conventional setup).

An additional benefit of the improved motherboard design is that a motherboard comprising only one rigid piece is much easier to mount as it can be screwed directly into the system.

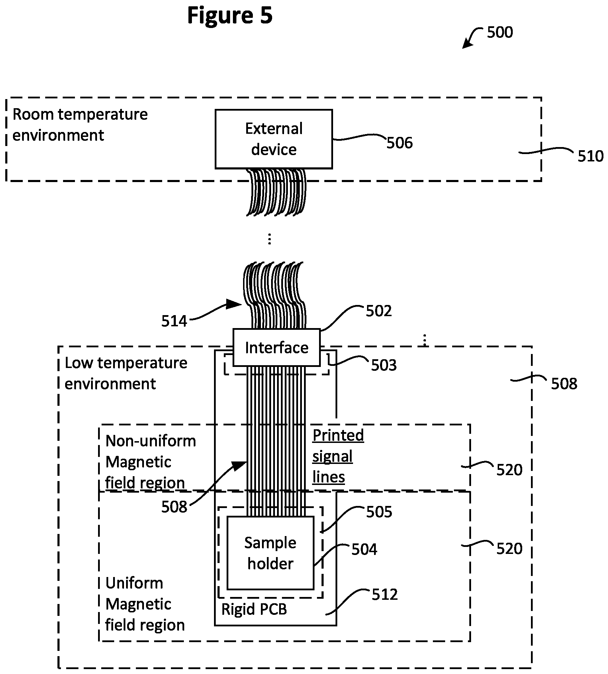

FIG. 5 shows an overall setup, with a system 500 with an external device 506 located in a room temperature environment 510 and a sample holder 504 located in a low temperature environment 508. For example, the low temperature environment 508 may be maintained within a sealable vacuum chamber. When sealed, the vacuum chamber forms a sealed enclosure whose interior is isolated from the room temperature environment 510. A device comprising a rigid PCB motherboard 512 is located within the low temperature environment 508, e.g. within the interior of the vacuum chamber. A sample holder 504 is attached or otherwise rigidly coupled to a sample region 505 of the rigid PCB motherboard 512. One end of the rigid PCB motherboard 512 extends to an electrical interface 502. Printed signal lines 508 are shown printed on the rigid PCB motherboard 512. The printed signal lines 508 extend between the sample holder 504 and a first portion of the electrical interface 502 to provide electrical signal paths therebetween. The first portion of the electrical interface 502 is rigidly coupled to an interface region 503 of the rigid PCB motherboard 512, such that the printed signal lines 508 are electrically coupled to the electrical interface 502. Although not depicted in FIG. 5, the system 500 also includes a refrigeration mechanism (such as a cryogen-free dilution refrigeration mechanism) configured to refrigerate the low temperature environment 508 to very low temperatures. The sample holder 504 is configured to hold a sample, such as a quantum chip, semiconductor sample etc. (not depicted) so that it is rigidly coupled to the sample holder 504 (and hence to the rigid PCB motherboard 512) and electrically coupled to the signal lines 508. As noted, in an alternative embodiment, the sample holder 504 is omitted, and a sample is directly attached to or otherwise directly rigidly coupled to the rigid PCB motherboard 512 and electrically coupled to the signal lines 508. The sample/sample holder 504 is held within a substantially uniform magnetic field region 522 (region of relatively low magnetic field gradient). However, the signal line(s) 508 intersect a non-uniform magnetic field region 520 (region of relatively high magnetic field gradient) between the sample/sample holder 504 and the interface 502.

An external device 506 (such as a measurement device, control device, or combined measurement and control device) is located in the room temperature environment 510 and coupled to a second portion of the interface 502 via second wires 514. In this example, the second wires 514 are not rigid. Rather, the second wires 514 take the form of low-triboelectric noise wires (e.g. enamel plated copper, constantan or bronze wires). In one embodiment, the second wires 514 are located within the low temperature environment 508, but outside of the non-uniform magnetic field region 520, meaning they are not susceptible to significant pickup induced noise from the non-uniform magnetic field. In another embodiment, the second wires 514 are external to the low temperature environment, in which case the interface 502 bridges the low temperate environment 508 and the room temperature environment 510 (for example, the interface 502 may be located at the edge of a vacuum chamber, bridging its interior and exterior). In one example, the electrical device 506 is indirectly connected to the interface 502 (e.g. via one or more additional interface and one or more additional sets of wires). In another example, the second wires 514 are located in the room temperature environment 510 and directly connect the external device 506 to the interface 502.

In some embodiments, one or more amplifiers (not depicted) located in the room temperature environment 510 are used to amplify signals received from the sample once they have exited the interior of the vacuum chamber. In one embodiment, the external device 506 receives signals measured from the sample (and, for example, uses those signals to measure an electrical property of the sample, such as resistance or impedance). In another embodiment, the external device 506 generates electrical control signals to the sample (e.g. to vary an electrical property of the sample). In some embodiments, the external device 506 performs both functions.

In some embodiments, double sided rigid PCB (with two layers) is used. In other embodiments, multilayer rigid PCB (having three or more layers) is used. Double sided rigid PCB comprises two rigid and stacked layers, each comprising a subset of the printed signal lines. Multi-layer rigid PCB comprises at least three rigid and stacked layers, each comprising a subset of the printed signal lines. Each enables a further reduction in pick-up loop area by stacking the signal lines.

FIG. 6 shows experimental results obtained using the improved motherboard setup (v6p0), benchmarked against a more conventional setup with non-rigid signal lines (v5p3). Each graph depicts a different measurement, each with a relatively short integration period. Of particular relevance, significant spikes in the lowest frequency region (between 0 and 100 Hz) are observed in the v5 spectra, which have been mitigated significantly in the v6 spectra.

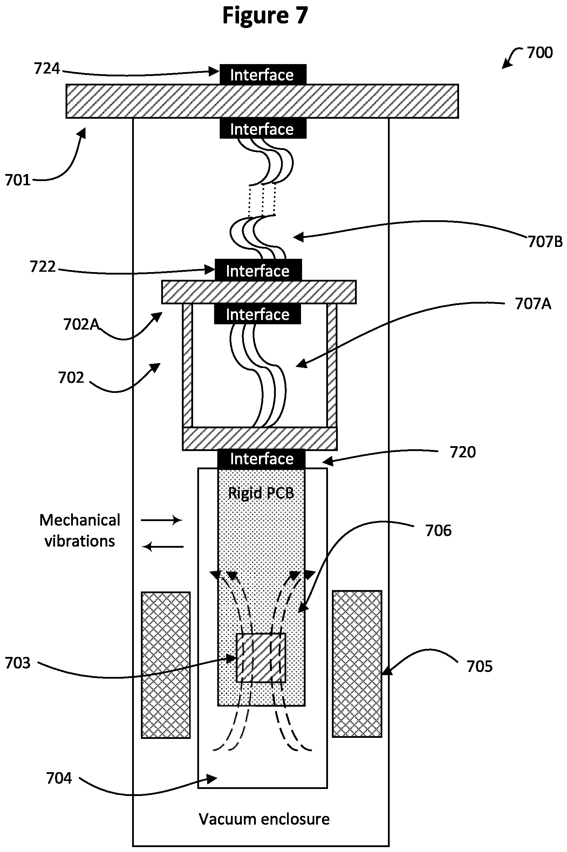

FIG. 7 shows an example implementation 700 of the system of FIG. 5. A sample 703 is supported by a rigid PCB motherboard 706 of the kind described above, in a magnetic field induced by a magnetic system comprising a superconducting magnet(s) 705 in this example. A fast sample exchange system 704 is shown supporting the sample 703 and the rigid PCB motherboard 706. The magnetic field is reasonably uniform across the volume of the sample 703. However, it becomes non-uniform towards its edges. The rigid PCB mother board 706 has rigid printed signal lines of the kind described above, which pass through the non-uniform magnetic field region, providing electrical connection between the sample 703 and a first electrical interface 720. The first electrical interface 720 connects the printed signal lines with first flexible wires 707A located in a mixer chamber 702, away from the non-uniform magnetic field region. A second electrical interface is connected to the first flexible wires 707A and located within a plate 702A of the mixer chamber 702, with third flexible wires 707B connecting the second electrical interface 722 (directly or indirectly) to a third electrical interface 724. The third electrical interface 724 is located at an edge of a sealed vacuum enclosure, in which the aforementioned components are located. The third electrical interface 724 provides electrical connectivity between the interior and exterior of the vacuum chamber, being located in a room temperature plate 701 at the top of the vacuum chamber.

According to a first aspect of the present disclosure, a device comprises: a rigid printed circuit board (PCB) comprising: a sample region, an interface region, and a printed signal line electrically coupling the sample region to the interface region; and a sample holder configured to hold a sample, the sample holder being rigidly coupled to the sample region and electrically coupled to the printed signal line.

In embodiments, the sample holder is configured to hold a quantum chip in electrical connection with the signal line.

In embodiments, the rigid PCB comprises a second printed signal line electrically coupling the sample holder with the interface region. In some such embodiments, there may be more than two signal lines. For example, in one embodiment, there are 96 lines distributed between eight PCB layers.

In embodiments, the rigid PCB comprises a first layer, the first layer comprising the printed signal line and the second printed signal line, and a second layer comprising a third printed signal line. The third layer may comprise a fourth signal line. Each layer may comprise more than two signal lines. In some embodiments, the rigid PCB comprises more than two layers, with each layer comprising multiple signal lines. In some such embodiments, the rigid PCT comprises eight layers.

In embodiments, the signal line and the second signal line exhibit a relative spacing of no more than 150 micrometers, in at least a region of the PCB. When used in a practical system, this region of narrow spacing may be located so as to align with a non-uniform magnetic field region. For example, this may be a region proximate or near to the sample region. In some embodiments, neighbouring lines are arranged so that, in use, the lines intersect an area of non-uniform magnetic field, and have a spacing of no more than 150 micrometers within that area. Outside of that area, they have greater spacing. For example, in an area where a quantum sample is installed, the lines may be separated by a few millimetres to enable them to be routed to different parts of the quantum sample. However, in use, the magnetic field in this area may be uniform, meaning larger wire separations in such areas are inconsequential.

In embodiments, the signal line and the second signal line exhibit a relative spacing of approximately 150 micrometers.

In embodiments, the signal line is configured to carry low-frequency electrical signals having a frequency of the order of 1 kHz or less.

According to a second aspect of the present disclosure, a system comprises a sample or sample holder; a magnetic system configured to apply a magnetic field across the sample or sample holder; an electrical interface; and a rigid printed circuit board (PCB) located within the enclosure, and comprising a printed signal line electrically coupling the sample or sample holder to the internal portion of the electrical interface, the printed signal line intersecting a non-uniform region of the magnetic field.

In embodiments, the system comprises the sample holder, and a sample held in the sample holder in electrical connection with the printed signal line.

In embodiments, the system comprises: an external device located outside of the enclosure and directly or indirectly coupled to the electrical interface, the device configured to: generate a control signal to the sample via the printed signal line, or measure a signal received from the sample via the printed signal line.

In embodiments, the sample is a quantum chip.

In embodiments, the system comprises an enclosure; and a dry dilution refrigeration mechanism configured to refrigerate the enclosure, the rigid PCB and the sample or sample holder located within the enclosure.

According to a third aspect of the present disclosure, a device comprises: a rigid printed circuit board (PCB) comprising: a sample region, an interface region, and a printed signal line electrically coupling the sample region to the interface region; and a sample rigidly coupled to the sample region and electrically coupled to the printed signal line.

In embodiments, the sample is a quantum chip.

In embodiments, the rigid PCB comprises a second printed signal line electrically coupling the sample with the interface region.

It will be appreciated that the above embodiments have been disclosed by way of example only. Other variants or use cases may become apparent to a person skilled in the art once given the disclosure herein. The scope of the present disclosure is not limited by the above-described embodiments, but only by the accompanying claims.

## Claims

1. A device comprising:
a rigid printed circuit board (PCB) comprising: a sample region, an interface region, and a printed signal line electrically coupling the sample region to the interface region; and
a sample holder configured to hold a sample, the sample holder being rigidly coupled to the sample region and electrically coupled to the printed signal line.

2. The device of claim 1, wherein the sample holder is configured to hold a quantum chip in electrical connection with the signal line.

3. The device of claim 1 or 2, wherein the rigid PCB comprises a second printed signal line electrically coupling the sample holder with the interface region.

4. The device of claim 3, wherein the rigid PCB comprises a first layer, the first layer comprising the printed signal line and the second printed signal line, and a second layer comprising a third printed signal line.

5. The device of claim 3 or 4, wherein the signal line and the second signal line exhibit a relative spacing of no more than 150 micrometers in at least a region of the PCB.

6. The device of claim 3 or 4, wherein the signal line and the second signal line exhibit a relative spacing of approximately 150 micrometers.

7. The device of any of claims 1 to 4, wherein the signal line is configured to carry low-frequency electrical signals having a frequency of the order of 1 kHz or less.

8. A system comprising:
a sample or sample holder;
a magnetic system configured to apply a magnetic field across the sample or sample holder;
an electrical interface; and
a rigid printed circuit board (PCB) located within the enclosure, and comprising a printed signal line electrically coupling the sample or sample holder to the internal portion of the electrical interface, the printed signal line intersecting a non-uniform region of the magnetic field.

9. The system of claim 8, comprising the sample holder, and a sample held in the sample holder in electrical connection with the printed signal line.

10. The system of claim 9, comprising:
an external device located outside of the enclosure and directly or indirectly connected to the electrical interface, the device configured to:
generate a control signal to the sample via the printed signal line, or
measure a signal received from the sample via the printed signal line.

11. The system of claim 9 or 10, wherein the sample is a quantum chip.

12. The system of any of claims 8 to 11, comprising:
an enclosure; and
a dry dilution refrigeration mechanism configured to refrigerate the enclosure, the rigid PCB and the sample or sample holder located within the enclosure.

13. A device comprising:
a rigid printed circuit board (PCB) comprising: a sample region, an interface region, and a printed signal line electrically coupling the sample region to the interface region; and
a sample rigidly coupled to the sample region and electrically coupled to the printed signal line.

14. The device of claim 13, wherein the sample is a quantum chip.

15. The device of claim 13 or 14, wherein the rigid PCB comprises a second printed signal line electrically coupling the sample with the interface region.
